Europäisches Patentamt

European Patent Office

Office européen des brevets

(11) Publication number: **0 304 076 B1**

# EUROPEAN PATENT SPECIFICATION

(45) Date of publication of patent specification: **11.11.92**

(51) Int. Cl.5: **C04B 35/60**, C04B 35/00, H01L 39/24, C30B 11/00, C30B 29/22, //B32B18/00

(21) Application number: **88113502.4**

(22) Date of filing: **19.08.88**

(54) Method of manufacturing superconductive products.

(30) Priority: **21.08.87 JP 207829/87**
**21.08.87 JP 207955/87**
**25.08.87 JP 210423/87**
**04.09.87 JP 221305/87**

(43) Date of publication of application:
**22.02.89 Bulletin  89/08**

(45) Publication of the grant of the patent:
**11.11.92 Bulletin  92/46**

(84) Designated Contracting States:
**DE GB**

(56) References cited:
**EP-A- 0 295 023**

**APPLIED PHYSICS LETTERS, vol. 51, no. 12, 21st September 1987, pages 943-945, American Institute of Physics, New York, NY, US; S. JIN et al.: "Fabrication of dense Ba2YCu3O7-delta superconductor wire by molten oxide processing"**

(73) Proprietor: **THE FURUKAWA ELECTRIC CO., LTD.**
**6-1, 2-chome, Marunouchi Chiyoda-ku Tokyo(JP)**

(72) Inventor: **Shiga, Shoji**
**771-2, Shukugo-cho**
**Utsunomiya-shi Tochigi-ken(JP)**
Inventor: **Uno, Naoki**
**2-6-508, Mitsuzawanishi-cho**
**Kanagawa-ku Yokohama-shi(JP)**
Inventor: **Tanaka, Yasuzo**
**8-6, Takinoue Naka-ku**
**Yokohama-shi(JP)**

(74) Representative: **Lehn, Werner, Dipl.-Ing. et al Hoffmann, Eitle & Partner Patentanwälte Arabellastrasse 4**
**W-8000 München 81(DE)**

JAPANESE JOURNAL OF APPLIED PHYSICS, vol. 27, no. 2, part 2, February 1988, pages L185-L187, New York, US; M. OKADA et al.: "Fabrication of Ag-sheathed Ba-Y-Cu oxide superconductor tape"

JOURNAL OF MATERIALS SCIENCE LETTERS, vol.6,1987, pages 990-992, Chapman and Hall Ltd; K. MATSUZAKI et al.: "Critical current density and electrical resistivity of high Tc superconductors in the La-Sr-Cu-O system prepared by the solidification method"

JOURNAL OF CRYSTAL GROWTH, vol. 85, 1987, pages 623-627, Elsevier Science Publishers B.V., Amsterdam, NL; C.A. COSTA et al.: "Synthesis of YBa2Cu3O7-x polycrystalline superconductors from Ba peroxide: First physico-chemical characterization"

PHYSICA C, vol. 156, no. 1, 1st August 1988, pages 57-61, Elsevier Science Publishers B.V., Amsterdam, NL; P.J. McGINN et al.: "Texture processing of YBa2Cu3O7-x by joule heat zone melting"

**Description**

The present invention relates to a method of manufacturing superconductive products, particularly those of high critical temperatures (Tc) and improved critical current densities (Jc).

Nb-Ti, Nb-Zr, Nb-Ti-Zr, $Nb_3Sn$, $V_3Ga$ and the like have been practically used as superconductive materials. These materials can be easily prepared by plastic-processing raw materials which have been compounded with the stabilizing metal such as Cu and Al. It has been well known that compounds such as $Nb_3Sn$ are diffused at the final process according to the bronze method.

However, these materials have critical temperatures (Tc) lower than about 20°C and need liquid helium, which is expensive and extremely low in temperature, as their cooling medium.

Superconductive materials of the ceramic or nonmetal type such as oxides having critical temperatures higher than the boiling point of cheap liquid hydrogen or nitrogen have been recently provided. These are stratified compounds of the $K_2NiF_4$ or three-layer perovskite type in the group of Ln-A-Cu-O wherein Ln represents Y, Sc or other rare earth elements and A denotes alkaline earth elements such as Ba and Sr. They are, for example, $YBa_2Cu_3O_{7-\delta}$ $ErBa_2Cu_3O_{7-\delta}$ $YBaSrCu_3O_{7-\delta}$ $(La_{1-x}Sr_x)_2CuO_4$ and the like and include even those with oxygen is replaced by fluorine, sulfur or the like.

The superconductive matters of the ceramic type can become superconductive at high temperature (Tc) and are expected to be used for power transmission lines of large capacity, magnets of high magnetic field and so on. However, it is extremely difficult to process the ceramic superconductive matters, as compared with those of the metal type such as Nb, and it has been therefore proposed that powder of the ceramic superconductive matters which has been previously subjected to firing treatment or which is not yet fired is used as raw material, and that this raw material powder is deposited on a base of desired form or molded, metal-covered and elongated to a wire product. These wire products are further processed to a twisted wire or coil, if necessary.

In the case of the superconductive matters or the oxide type such as $YBa_2Cu_3O_{7-\delta}$, therefore, raw material powder of oxide and carbonate, for example, is pre-fired to provide a compounded oxide, which is powdered, then made to fill a metal sheath, compressed by a rubber press to raise its density, and then processed to a wire product of desired diameter. These wire products are twisted together to a twisted wire or processed to a coil, if necessary, which is further sintered in air or oxygen atmosphere.

Even if the powder of the superconductive matter is made to fill the metal sheath and processed to the wire product according to the conventional method of manufacturing the ceramic superconductive products, the density of the powder filling the metal sheath is low, ranging about 70%, and when this powder made to fill the metal sheath like this is processed to a twisted wire or cable and then sintered, its volume is contracted more than 20%. Clearance is thus formed between the powder and the metal sheath and this causes the thus-made products to be inferior in their superconductivity.

Even when the superconductive matter is elongated to a wire product, it is difficult to arrange its crystals in a direction because it is powder made to fill the metal sheath. This also makes it impossible to provide superconductive products having excellent superconductivity.

An object of the present invention is to provide a method of manufacturing ceramic superconductive products high in density and excellent in super-conductivity.

According to the present invention, there can be provided a method of manufacturing superconductive products comprising heating superconductive matter or elongate body including its precursor to a temperature higher than its or its precursor's melting point to melt it or its precursor, and then solidifying and cooling it in such a way that is re-crystalized to have an orientation in the longitudinal direction of its elongate body.

1) Superconductive materials or their precursors deposited on a heat-resisting base, 2) wire-like products made by filling the superconductive matter or its precursor in a metal sheath, and 3) those formed to various desired shapes by bending a plurality of the wire-like products, for example can be cited as the superconductive matters or elongate bodies including their precursors in the present invention.

Products having excellent superconductivity can be prepared by the present invention using super-conductive materials or their precursors of the oxide type in the groups of Re-Ba-Cu-O (Re: rare-earth element), Bi-Sr-Ca-Cu-O and Tℓ-Ba-Ca-Cu-O.

When materials having this stratified perovskite structure are used, the amount of oxygen entering into and coming out of the system must be controlled because phase transition occurs, keeping oxygen in and out, in the process of cooling the materials after they are solidified. It is therefore desirable that heating and cooling of the super-conductive materials or their precursors are carried out in oxygen-abundant atmosphere, particularly in an atmosphere in which oxygen partial pressure is 0.2 - 50 atm.

Particularly when the superconductive matter or its precursor made to fill the metal sheath is heated

3

EP 0 304 076 B1

and cooled, the supply of oxygen to the material or its precursor through the metal sheath is not sufficient. It is therefore preferable that the material or its precursor is heated in oxygen-abundant atmosphere or that a small amount of metal peroxide such as silver peroxide and copper oxide is previously mixed, as oxidizing agent, with the superconductive material or its percursor which is to be made to fill the metal sheath.

The material of the percursor of the superconductive matter may be selected from the group consisting of an oxide, a hydroxide, a halide, a salt of an inorganic acid such as a carbonate or a nitrate, an acetate, an oxalate, an alcoxide, which all include a constituent element of an oxide superconductive body including at least an alkali earth metal and copper.

The material of which the metal sheath is made preferably has a melting point higher than that of the superconductive material or its percursor. It is also preferable that the metal sheath material is less readily oxidized. Stainless steel, silver, platinum and the like can be used as the metal sheath material. It is needed that the temperature at which the superconductive matter or its precursor made to fill the metal sheath is heated and melted is lower than the melting point of the metal sheath because the melted superconductive matter must be held by the metal sheath. When this temperature becomes 200 degrees C higher than the melting point of the super-conductive matter, the vapor pressure of the melt becomes high and reaction thereof with the metal sheath becomes severe. It is therefore preferable that the temperature for heating and melting the superconductive matter or its precursor is kept in a range of just a little higher than the melting point of the superconductive matter to 200°C.

Various embodiments of the present invention will be described in more detail.

An embodiment of the present invention comprises a first Process of fixing a superconductive matter or its precursor of the ceramic type onto a heat-resisting continuous base, and a second process of continuously heating the fixed matter or precursor from one end thereof to the other to a temperature higher than the melting point of the superconductive matter, melting at least a part of it and then successively cooling and re-crystalizing it.

The first process is carried out by coating the superconductive matter or its precursor on the heat-resisting continuous base according to the vapor-depositing or sputtering manner. When a relatively thick coating of the matter is needed in this case, it may be arranged that fine powder of the super-conductive matter or its precursor is mixed with a binder and fixed to the base or molded or pressed onto the base and then sintered. It may also be arranged that the fine powder is uniformly fixed and sintered onto the base according to the flame spraying technique.

According to the second process, the base on which the superconductive matter or its precursor of the ceramic type has been coated is continuously heated from one end thereof to the other to melt the matter or its precursor and the thus-melted matter or precursor is then cooled and re-crystalized.

When the superconductive materials are of the oxide type, the first and second processes are carried out in an atmosphere of $O_2$. Electric furnace, beam, flame, plasma or the like can be used as the heating source. Cooling is carried out at any optional speed and temperature in such a way that the matter- or precursor-covered base is continuously moved from hot melting section to low temperature section.

The first and second processes may be combined as a continuous process or used as a process independent of the other.

Wires, filaments, tapes, strips and the like made by inorganic matter such as Pt, Ag, Cu, Fe, stainless steel, Ni, Co, W, Mo or their alloys, carbon, SiC, $Al_2O_3$ or $SiO_2$ can be used as the heat-resisting continuous base.

The superconductive matter which has been thinly fixed and covered on the heat-resisting continuous base is heated and melted at a temperature of about 1000 - 1600°C. Excessive melting of the matter is not preferable because the matter is decomposed and evaporated to change its composition. In order to prevent the part of oxygen from being reduced, it is necessary that the superconductive matter is processed in $O_2$ or pressurized $O_2$ atmosphere. It is preferable that $O_2$ partial pressure is usually in a range of 0.2 - 50 atm.

In the case where the superconductive matter or its precursor fixed on the base is too thick, it loses its flexibility and becomes fragile when used as a continuous strip product or the like. It is therefore preferable to keep the superconductive matter thin on the base. Particularly, the melted superconductive matter must be held on the base, keeping its surface tension and viscosity balanced with gravity and other external mechanical force. When the melted superconductive matter is thin on the base, it can be easily controlled and uniformly cooled. In addition, it is advantageous in its being re-crystalized in one direction. It is preferably in range of 0.1 - 50 $\mu$m. When it is too thin, it cannot serve as a conductor because it has no sufficient current-carrying capacity.

The continuous heat-resisting base must have heat resistance durable against any treatment employed

4

by the present invention. In addition, it must have, as a conductor, mechanical strength, plasticity, heat conductivity and the like. In order to economically increase the current-carrying capacity essential to the practical superconductive products, it is preferable that the diameter of the wire-like base or thickness of the strip-like base is made small. Needless to say, too-large bases reduce the effective sectional area of the conductor. It is therefore preferable to keep the diameter or thickness of the wire or strip-like base in a range of 0.1 - 500 $\mu$m.

This embodiment of the present invention comprises the above-mentioned two processes, but other processes may be added to these two processes, if necessary. The crystal structure and composition of the superconductive products may be adjusted by heat or $O_2$ plasma treatment after the re-crystalizing process. Further, the superconductive products may be covered by metal such as Ag, Cu, Al and Sn to keep them protected from air outside and increase their heat conductivity to stabilize them. They may be covered by ceramics or organic matters.

Another embodiment of the present invention will be described.

This second embodiment comprises filling either of ceramic superconductive matter powder or its precursor powder which has been previously fired into a metal sheath and a) heating the powder in the metal sheath to a predetermined temperature higher than the melting point of the powder but lower than the melting point of the metal sheath to melt it and process it together with the metal sheath to a wire, or b) processing the powder in the metal sheath to a wire having a predetermined diameter, then continuously and locally heating this wire to a temperature higher than the melting point of the superconductive matter or its precursor to melt the powder in the metal sheath, and continuously cooling and unidirectionally solidifying it.

The process a) of melting the powder filled in the metal sheath and elongating it together with the metal sheath to a wire will be described.

The elongating step of the process a) is carried out at high temperature. Therefore, the elongating step using no die but tension is more advantageous than the one using dies. It is preferable at this elongating step using no die that one passage reduction is made small from the viewpoint of controlling the diameter of the wire and that the heating, melting and elongating steps are repeated many times.

The powder reacts with itself or with a metal peroxide in the course of the heating, melting and elongating steps to thereby adjust its crystal structure and the amount of oxygen, so that a complete ceramic superconductive product can be provided. And when it is quickly cooled after the elongating step, its crystals are made fine to further enhance its properties.

In the case of those superconductive matters whose phase transition occurs at the quick cooling step after the elongating one, their phase transition must be caused without failure by quickly cooling them at a temperature higher than their phase transition temperature and then gradually cooling them at a temperature lower than it, or by quickly cooling them to a temperature lower than their phase transition temperature, beating them again to a temperature higher than it and then gradually cooling them.

The ceramic superconductive products thus provided are extremely high in their filled density and their superconductive properties can be made extremely excellent when their crystals are made fine by the quick cooling step.

The process b) of area-reducing the metal sheath in which the powder has been filled to form a wire having a predetermined diameter and heat-treating this wire will be described.

According to the so-called zone melting manner, the wire in which the powder of the superconductive matter has been filled is continuously heated and then cooled and the powder is thus melted and unidirectionally solidified.

As a result, the superconductive products thus made can have a higher filled density and an orientation of their crystals to enhance their superconductivity.

Since the powder of the superconductive matter which is to be melted has conductivity, it is preferable that the zone melting manner comprises heating and melting the wire through a small-sized high frequency coil and cooling and solidifying it by moving it in its longitudinal direction at a low speed. Its diameter is preferably in a range of about 0.5 - 1 mm$\phi$ from the viewpoint of its flexibility after solidification and its being easy to undergo the zone melting manner.

A further embodiment of the present invention will be described.

This third embodiment comprises filling the powder of a ceramic superconductive matter into a metal pipe, area-reducing the metal pipe to a wire having a predetermined diameter, bending this line or a plurality of the wires to a desired form, locally and continuously heating the thus-formed elongate body to a temperature higher than the melting point of the superconductive matter to melt the powder in the pipe and then continuously cooling the melt to solidify it unidirectionally.

According to the third embodiment using the so-called zone melting manner, the wire in which the

5

superconductive matter powder has been filled is processed to a desired form and the incorporation thus made is continuously heated and then cooled to melt the powder in the wire and solidify it in a direction, so that the superconductive product thus obtained can have a higher filled density and orient its crystals to enhance its superconductivity.

It is preferable that the zone melting manner is intended to use a small-sized high frequency coil to heat and melt the powder in the formed wire and cool and solidify it, keeping it moved in its longitudinal direction at a low speed, because the superconductive matter powder which is to be melted has conductivity. The outer diameter of each of the wires is preferably in a range of about 0.5 - 1 mm$\phi$, considering their flexibility and their readiness to accept the zone melting manner. When they are twisted to form a twisted wire, however, no particular limitation is applied to the outer diameter of the twisted wire. When they are used as coils, no limitation is also applied to their outer diameters, however they may be used in the form of a single wire or twisted wires. The zone melting manner may be carried out in such a way that one end of the super-conductive coil in the metal sheath is passed through a loop of the high frequency heating coil and that the superconductive coil is moved in its longitudinal direction while being rotated.

According to the method of the present invention, the elongate body including superconductive matter or its precursor is heated to a temperature higher than the melting point of the superconductive matter or its precursor and it is thus melted and then cooled and re-crystalized. Therefore, the superconductive products thus obtained can have a higher density and a structure in which their crystals can be oriented in any direction, thereby enhancing their super-conductivity.

More concretely, the superconductive matter fixed and coated on the continuous base is melted from one end thereof to the other and then cooled successively according to the first embodiment of the present invention. When the cooling speed and the like are controlled, therefore, the crystals of the matter can be easily oriented. As the result, the super-conductive product thus obtained can have uniform and dense crystals which are oriented. Particularly in the case of the superconductive matters of the oxide type, it is important to orient their crystals because they have anisotropy and exhibit more excellent superconductivity in the directions of axes a and b, as compared with that in the direction of axis c.

According to the second embodiment of the present invention, the superconductive matter powder is filled in the metal sheath and a) heated to enable the melted powder to be elongated or b) area-reduced to form a wire having a predetermined diameter, and this wire is then cooled continuously to solidify the melted powder in a direction. Therefore, superconductive products thus obtained can have dense and uniform crystals which are oriented, thereby enhancing their super-conductivity.

According to the third embodiment of the present invention, the ceramic superconductive matter powder is filled in the metal sheath and area-reduced to form a wire having a predetermined diameter. This wire or these wires are then bent to an elongate body which has a predetermined form, and this elongate body is continuously and locally heated to a temperature higher than the melting point of the superconductive matter to melt the ceramic superconductive matter powder in the elongate body. The melted powder is then continuously cooled and solidified to orient its crystals in a direction. Therefore, the super-conductive products thus obtained can have a higher density and a structure in which their crystals are oriented in one direction, thereby enhancing their superconductivity.

This invention can be more fully understood from the following detailed description when taken in conjunction with the accompanying drawings, in which:

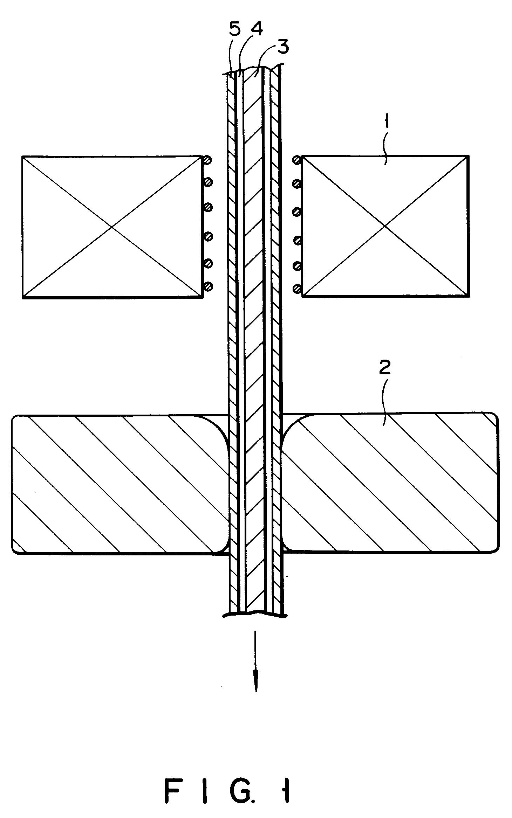

Fig. 1 shows an example of the heating and cooling apparatus of the vertical type through which superconductive lines made according to the present invention are heated and cooled.

The present invention will be described in more detail, referring to some embodiments thereof.

An embodiment of the present invention will be described citing examples 1 - 7 and comparison examples 1 - 2.

Example 1:

A wire of Mo which was 100 $\mu$m$\phi$ was coated with MgO of 1.0 $\mu$m thickness according to the sputtering manner. The wire thus obtained was painted with a paste, which had the following composition, according to the die method.

YBa$_2$Cu$_3$O$_{7-\delta}$:      1.5 $\mu$m$\phi$ (average particle size) 75wt%
ethyl cellulose:      10wt%
butyl carbinol:      remaining weight percentage

The painted wire was processed for a minute at 600°C and then for 25 minutes at 950°C in an air furnace. A wire material having a coating of 17 $\mu$m thereon was thus obtained. The wire material was continuously passed through a high frequency heating furnace in a 15atm atmosphere of $O_2$. This furnace included a portion of about 30 mm which was heated to 1300°C, and the temperature at the outlet of the furnace was 500°C.

The interval between the high frequency heating section in the furnace and the outlet of the furnace was 750 mm, and the speed of the wire material moving in the furnace was 100 mm/min. The thickness of the superconductive layer on the finished line product was 15 $\mu$m.

Example 2:

The thickness of the paste painted on the base material according to the die manner in Example 1 was adjusted to be about 1.3 $\mu$m and the base material thus obtained was processed in same fashion as in Example 1. The thickness of the superconductive layer on the finished wire product thus obtained was 0.9 $\mu$m.

Example 3:

MgO wire of 300$\mu$m$\phi$ was used instead of Mo wire of 100 $\mu$m$\phi$ and $Y_{0.7}Er_{0.3}Ba_{1.5}Sr_{0.5}Cu_3O_{7-\delta}$ was used instead of $YBa_2Cu_3O_{7-\delta}$. The thickness of the paste painted was 8 $\mu$m, the melting temperature in the furnace was 1270°C, and the outlet temperature of the furnace was 500°C. The speed of the wire material in the furnace was 500 mm/min. The thickness of the superconductive layer on the finished wire product thus obtained was 7.3 $\mu$m.

Example 4:

The thickness of the paste painted in Example 3 was changed to about 40 $\mu$m and the wire material thus obtained was processed in same manner as in Example 3. A wire product with a 3.7 $\mu$m thick superconductive layer was thus obtained.

Example 5:

The wire material in Example 1 was further processed for 3 hours in $O_2$ atmosphere of 700°C.

Example 6:

The wire material in Example 2 was further processed for 15 minutes in a low temperature $O_2$ plasma (about 200°C).

Comparison Example 1:

The re-crystalizing process in Example 1 was carried out in 1 atm atmosphere of $N_2$.

Comparison Example 2:

The thickness of the paste painted in Example 3 was changed to about 75 $\mu$m and the painted wire was processed in same manner as in Example 3.

Critical current density (Jc) was measured in $N_2$ liquid (77K) about each of the wire products thus obtained. External magnetic field (H) was set 0 Tesla and 0.5 Tesla. Results thus obtained were shown in Table 1. Critical current density (Jc) was also measured under same condition about Examples 1 - 6 which were not re-crystalized yet, and results thus obtained are also shown in Table 1.

Table 1

| Wire material | No. | Jc(A/cm$^2$) | |
|---|---|---|---|
| | | H = 0Tesla | H = 0.5Tesla |
| Example 1 | 1 | $407 \times 10^3$ | $85 \times 10^3$ |
| — 2 | 2 | 680 | 390 |
| — 3 | 3 | 930 | 660 |
| — 4 | 4 | 550 | 290 |
| — 5 | 5 | 630 | 300 |
| — 6 | 6 | 710. | 420 |
| Comparison Example 1 | 7 | 0 | 0 |
| — 2 | 8 | 58 | 9 |
| Example 1 prior to re-crystalizing process | 9 | 0.5 | 0 |
| — 2 | 10 | 0.7 | 0 |
| — 3 | 11 | 0.8 | 0 |
| — 4 | 12 | 0.5 | 0 |
| — 5 | 13 | 0.5 | 0 |
| — 6 | 14 | 0.7 | 0 |

As apparent from the results shown in Table 1, it has been found that superconductive wire products whose permissible superconductive current is increased to a great extent can be obtained according to the present invention. As the paste painted becomes thicker, current density seems to become lower. The comparison examples having particularly thick coating show much better results than those of the examples prior to the re-crystalizing process but worse results than those of the examples having thin coating. Comparison example 1 was processed in an atmosphere in which no $O_2$ was included, and it was not finished as a superconductive product accordingly.

Example 7:

Fe - Ni alloy wire of 0.5 mm$\phi$ on which Ag was plated was used as a base material and a paste having the following composition was painted on the base material according to the die manner.

$ErBa_2Cu_3O_{7-\delta}$ :      2.0 $\mu$m$\phi$ (average particle size) ( $\delta$ = 0.1 - 0.3) 75wt%

ethyl cellulose:      10wt%

butyl carbinol:      remaining weight percentages

The wire on which this paste had been painted was processed for 1 minute at 600°C and then for 25 minutes at 950°C in an air furnace. A coating layer of 30 $\mu$m was obtained.

The wire material thus obtained was continuously passed, in $O_2$ atmosphere of 1 atm, through a heating and cooling apparatus of the vertical type in which a high frequency heating furnace and a cooling section were combined as shown in Fig. 1. In Fig. 1, numeral 1 represents the high frequency heating furnace, 2 the cooling section consisting of AIN water cooling dies, 3 Fe - Ni alloy wire, 4 Ag-plated layer, and 5 $ErBa_2Cu_3O_{7-\delta}$.

The wire material which is made by plating Ag layer 4 on Fe - Ni alloy wire 3 to form the base material and coating Er $Ba_2Cu_3O_{7-\delta}$ 5 on the base material is heated to 1400°C in high frequency heating furnace 1, 20 mm long, and is thus melted thereon. The wire material thus obtained is quickly cooled and solidified by water cooling dies 2 made of AIN and arranged just under high frequency heating furnace 1. The cooling speed is charged by varying both the interval between AIN water cooling dies 2 and high frequency heating furnace 1 and the speed of the wire material fed.

The superconductive layer formed on the wire material is solidified in one direction when the cooling speed and temperature gradient are appropriate, so that its crystals can be oriented in such a way that axes c of its crystals of the perovskite type are arranged perpendicular to the longitudinal direction of the wire material.

The cooling speed most suitable for obtaining this orientation of crystals is in a range of 20 - 100°C/sec. The interval between high frequency heating furnace 1 and water cooling AℓN dies 2 is 20 mm this time and the speed of the wire material fed is in a range of 20 - 100 mm/min. The wire material was heated and cooled in this example keeping the feeding speed of the wire material to be 10, 20, 50, 100 and 200 mm/min. The thickness of the superconductive layer on the finished line product was 25 $\mu$m in any of these cases.

The orientation of the wire product thus obtained was measured and its critical current density (Jc) was also measured at the liquid nitrogen temperature (77K). The external magnetic field (H) under which the critical current density (Jc) was measured was 1T. The orientation was expressed by those percentages which were obtained by dividing the sum of integrated strengths of (OO1) diffracting peaks calculated from XRD (X-ray diffracting device) by the sum of integrated strengths of these and other diffracting peaks. Results thus obtained are shown in Table 2.

Table 2

|  | Feeding speed (mm/min) | Orientation (%) | Jc at 77K 0Tesla (A/cm$^3$) |
|---|---|---|---|
| Example 7 - 1 | 10 | 87 | 580 × 10$^3$ |
| — 7 - 2 | 20 | 90 · | 720 × 10$^3$ |
| — 7 - 3 | 50 | 95 | 980 × 10$^3$ |
| — 7 - 4 | 100 | 90 | 700 × 10$^3$ |
| — 7 - 5 | 200 | 85 | 500 × 10$^3$ |

As apparent from Table 2, high Jc are obtained even in the external magnetic field of 1T thanks to the excellent orientation of crystals in this Example. The orientation of crystals seems to be reduced when the speed of the wire material fed is too low or too high.

Another embodiment of the present invention will be described referring to examples 8 through 11 and comparison examples 3 through 4.

Example 8:

A raw material powder was made by mixing 2% of powdered silver peroxide with ceramic superconductive matter powder having a composition of previously burned $YBa_2Cu_3O_{7-\delta}$ ($\delta$ = 0.1 - 0.3). The raw material powder was filled into a platinum pipe which had an outer diameter of 10 mm$\phi$, an inner diameter of 9.5 mm$\phi$ and a length of 100 mm, and the platinum pipe was then closed at one end thereof. The platinum pipe filled with the raw material powder was held vertical and its open end upside by the chuck made of zirconia and moved downward in a high frequency coil which had an inner diameter of 20 mm$\phi$ and a length of 50 mm, adding a tension of 98 MPa (10kgf/mm$^2$) to the pipe to elongate it to have an outer diameter of 8 mm$\phi$ while melting the raw material powder made to fill it. Heating, melting and elongating were repeated 12 times to provide a ceramic superconductive wire product which had an outer diameter of 1 mm$\phi$. The wire material was quickly cooled and solidified by water sprayed at the outlet of the high frequency coil in the course of the final elongating process.

Example 9:

Nitrates Y, Ba and Cu were mixed at a mol ratio of Y : Ba : Cu = 1 : 2 : 3 and the mixture of these nitrates was coprecipitated with oxalic acid. The deposition thus obtained was fired for 6 hours at 500°C in an oxygen atmosphere after its being dried, and then powdered to provide a ceramic superconductive precursor powder which was to be used as raw material powder. This raw material powder was filled in an SUS 304 stainless steel pipe which had an outer diameter of 10 mm$\phi$, an inner diameter of 9 mm$\phi$ and a length of 100 mm, and the pipe was then closed at one end thereof. The pipe in which the raw material powder had been filled was heated, melted and elongated, using the same high frequency coil and under the same condition as in Example 8, in a quartz chamber which had an inner diameter of 50 mm$\phi$ and a length of 800 mm and through which oxygen was being passed at a rate of 2 $\ell$/min. A ceramic super-conductive wire product having an outer diameter of 1 mm$\phi$ was thus prepared.

Comparison example 3:

The ceramic superconductive matter powder having a composition of $YBa_2Cu_3O_{7-\delta}$ ($\delta$ = 0.1 - 0.3) was filled in the SUS 304 stainless steel pipe which had an outer diameter of 10 mm$\phi$, an inner diameter of 9 mm$\phi$ and a length of 100 mm, and the pipe was closed at both ends thereof by welding. The pipe was then elongated by roller dies to have an outer diameter of 1 mm$\phi$ and sintered for 10 hours at 900°C in atmosphere.

Filled density, crystal particle size, critical temperature (Tc) and critical current density (Jc) were measured about three kinds of these Examples 8, 9 and Comparison example 3. Results thus obtained are shown in Table 3.

Table 3

| | Field density (%) | Crystal Particle size * ($\mu$m) | Tc (K) | Jc at 77K 0tesila ($A/cm^2$) |
|---|---|---|---|---|
| Example 8 | 99.5 | 1 | 94 | $4 \times 10^3$ |
| — 9 | 99.5 | 1 | 94 | $4 \times 10^3$ |
| Comparison example 3 | 90 | 20 | 92 | $2 \times 10^2$ |

* Average value

As apparent form Table 3, the products prepared according to the present invention are higher in filled density, smaller in crystal particle size and much higher in Jc, as compared with the Comparison example.

Example 10:

Silver peroxide powder of 2% was mixed with the ceramic superconductive matter powder having a composition of $YBa_2Cu_3O_{7-\delta}$ ($\delta$ = 0.1 - 0.3) to provide a mixed powder, which was filled (filled density = 60%) in a platinum pipe which had an outer diameter of 10 mm$\phi$, an inner diameter of 9.5 mm$\phi$ and a length of 100 mm. The platinum pipe in which the mixed powder had been filled was elongated, using roller dies, till it had an outer diameter of 1mm$\phi$ and a wire material thus obtained was passed through a high frequency coil which had an outer diameter of 5 mm$\phi$ and a length of 20 mm, to thereby melt the powder in the line material by high frequency heat. Zone melting was carried out feeding the wire material in the longitudinal direction thereof at a speed of 1mm/min through the continuous melting zone. Air cooling was continuously applied to the wire material to solidify the melted powder in the wire material in one direction.

The wire product thus obtained had a high filled density of 99% and a remarkable orientation in which its crystal faces C were arranged in its longitudinal direction. Therefore, critical temperature (Tc) and critical current density (Jc) were high in the longitudinal direction of the wire product, showing Tc of 94K and Jc of $7 \times 10^3$ A/cm² under liquid nitrogen temperature 0Tesla.

Example 11:

$Y_2O_3$, $BaCO_3$ and CuO were used as oxide raw material powder and they were mixed in the automatic mortar at a mol ratio of Y : Ba : Cu = 1 : 2 : 3. This mixture was calcined for 20 hours at 920°C in oxygen atmosphere and then powdered to make a secondary raw material powder. Various amounts of CuO powder shown in Table 4 were added to this secondary raw material powder of 100 weight parts and mixed in the automatic mortar to prepare a mixed oxide raw material powder. The mixed oxide raw material powder was extruded and coated, at 500°C, directly on a Pt - Rh alloy line (or core material) which had a diameter of 1 mm$\phi$ to thereby provide a composite wire material having an outer diameter of 1.8 mm$\phi$. The composite line material was subjected to isothermal heating treatment for 5 hours at various temperatures shown in Table 4 in oxygen atmosphere, using the electric furnace of the batch type, then melted on the surface thereof, and gradually cooled at a cooling speed of 3°C/min. Or the composite line material was held for about 5 hours under various heat treating temperatures shown in Table 4, continuously passed through the electric furnace, which had a temperature gradient of 100°C/cm, in the longitudinal direction thereof and gradually cooled at an average cooling speed of 1°C/min to the room temperature. Density, critical current density (Jc) and whether or not anomalous phase such as $Y_2BaCuO_5$ was caused were examined relating to the superconductive wire product of the oxide type thus obtained. Results are shown in Table 4. The density in Table 4 represents ratios (%) relative to true density. Jc are values obtained under liquid nitrogen temperature (77K) and 0Gauss and calculated in terms of the whole oxide layer including the layer of CuO.

Table 4

| | CuO (Wt part) | Heat-treating manner | Heat treating temp. (°C) | Density (%) | Jc (A/cm$^2$) | Anomalous phase |
|---|---|---|---|---|---|---|
| Example 1 - 1 | 10 | Continuous | 1100 | 97 | 4480 | No |
| Example 1 - 2 | 10 | - | 1300 | 99 | 4530 | - |
| Comparison example 1 - 3 | 10 | Isothermal | 1450 | 99 | 210 | - *2 |
| Comparison example 1 - 4 | 0 | - | 1050 | 98 | 180 | Found *1 |

*1 : $Y_2BaCuO_5$ was caused
*2 : remarkably reacted with Pt - Rh

Example 12:

The mixed oxide raw material powder prepared in same manner as in Example 11 was filled in a Pt - Rh alloy pipe (outer diameter: 10 mm$\phi$, inner diameter: 7 mm$\phi$) and this pipe was cold-worked to a composite wire which had an outer diameter of 0.5 mm$\phi$. The composite wire was thereafter heat-processed in same way as in Example 11. Same examination as in Example 11 was conducted about the superconductive wire product of the oxide type thus obtained. The conditions under which the superconductive wire product of the oxide type was prepared and examination results obtained about this wire product are shown in Table 5.

As apparent from Tables 4 and 5, any of the oxide superconductive wire products (1 - 1, 1 - 2 and 2 - 1, 2 - 2) prepared according to the present invention has no anomalous phase and is high in density and critical current density. On the other hand, both of comparison examples 1 - 3 and 2 - 3 prepared under such heat-treating temperatures as not included in the temperature range of the present invention are low in Jc. Particularly in the case of comparison examples 1 - 4 and 2 - 4 in which no CuO powder was mixed, anomalous phase ($Y_2BaCuO_5$) is caused and in the case of comparison examples 1 - 3 and 2 - 3 whose heat-treating temperatures were too high, the mixed oxide raw material is remarkably reacted with the core or Pt - Rh alloy.

11

Table 5

| | Material of metal pipe | CuO (Wt part) | Heat-treating manner | Heat-treating temp. (°C) | Density (%) | Jc (A/cm²) | Anomalous phase |
|---|---|---|---|---|---|---|---|
| Example 2-1 | Pt - Rh | 10 | Conti-nuous | 1050 | 96 | 5240 | No |
| Example 2-2 | -- | 10 | -- | 1300 | 99 | 5380 | -- |
| Comparison example 2-3 | Pt - Rh | 10 | Isoth-ermal | 1450 | 99 | 240 | -*2 |
| Comparison example 2-4 | -- | 0 | -- | 1050 | 97 | 200 | Found*1 |

*1 : $Y_2BaCuO_5$ was caused.

*2 : remarkably reacted with Pt - Rh.

Example 13:

Bi₂O₃, SrCO₃, CaCO₃ and CuO were used as oxide raw material powder and they were mixed in the automatic mortar at a mol ratio of Bi : Sr : Ca : Cu = 1 : 1 : 1 : 2. The mixture was calcined for 20 hours at 820°C in atmosphere. A composite wire product was thereafter prepared according to same manner as in Example 11 and heat process was applied to the composite wire product at various temperatures shown in Table 3 according to same manner as in Example 11 except that it was heat-processed in atmosphere. Same examination as in Example 11 was conducted about the superconductive wire product of the oxide type thus obtained and results are shown in Table 6.

Example 14:

The mixed oxide raw material powder prepared in same manner as in Example 13 was filled in an Ag or Pt - Rh alloy pipe (outer diameter: $10\mu m\phi$, inner diameter: 7 mm$\phi$) and the pipe was cold-worked to a composite wire whose outer diameter was 0.5 mm$\phi$. Same heat process as in Example 13 was thereafter applied to the composite wire and same examination as in Example 11 was conducted about the superconductive line product of the oxide type thus obtained. Conditions under which the superconductive wire product of the oxide type was prepared and examination results obtained are shown in Table 7.

As apparent from Tables 6 and 7, any of the superconductive wire products of the oxide type (3 - 1 -- 3 - 7 and 4 - 1 -- 4 - 6) has no anomalous phase and is high in density and critical current density

Table 6

|  | CuO (Wt part) | Heat-treating manner | Heat treating temp. (°C) | Density (%) | Jc (A/cm$^2$) | Anomalous phase |
|---|---|---|---|---|---|---|
| Example 3 - 1 | 0.1 | Isothermal | 1200 | 96 | 580 | No |
| 3 - 2 | 1.0 | - | 1050 | 97 | 690 | - |
| 3 - 3 | 5 | - | 1350 | 99 | 670 | - |
| 3 - 4 | 30 | - | 950 | 94 | 510 | - |
| 3 - 5 | 10 | Continuous | 950 | 94 | 720 | - |
| 3 - 6 | 10 | - | 1050 | 97 | 860 | - |
| 3 - 7 | 10 | - | 1250 | 98 | 870 | - |
| 3 - 8 | 0.05 | Isothermal | 1050 | 95 | 35 | Found[*3] |
| Comparison examples 3 - 9 | 35 | - | 1050 | 97 | 80 | No |
| 3 - 10 | 10 | - | 1400 | 99 | 53 | - [*2] |
| 3 - 11 | 0 | - | 1050 | 97 | 30 | Found[*3] |

*2 : remarkably reacted with Pt - Rh
*3 : anomalous phases (CaCuO and BiSrO groups) are caused.

(Jc). When they are continuously passed through the electric furnace which has a temperature gradient and their crystals are thus oriented, particularly Jc is

Table 7

| | Material of metal pipe | CuO (Wt part) | Heat-treating manner | Heat-treating temp. (°C) | Density (%) | Jc (A/cm²) | Anomalous phase |
|---|---|---|---|---|---|---|---|
| Example 4 - 1 | Pt - Rh | 0.1 | Isothermal | 1200 | 96 | 270 | No |
| 4 - 2 | - | 1.0 | - | 1050 | 97 | 330 | - |
| 4 - 3 | Ag | 10 | - | 1350 | 99 | 250 | - |
| 4 - 4 | Pt - Rh | 10 | Continuous | 950 | 94 | 650 | - |
| 4 - 5 | - | 10 | - | 1050 | 97 | 760 | - |
| 4 - 6 | - | 10 | - | 1250 | 99 | 790 | - |
| 4 - 7 | | 0.05 | Isothermal | 1050 | 95 | 41 | Found*3 |
| Comparison examples 4 - 8 | Pt - Rh | 35 | - | 1050 | 97 | 83 | No |
| 4 - 9 | - | 10 | - | 1400 | 99 | 46 | *2 |
| 4 - 10 | - | 0 | - | 1050 | 97 | 25 | Found*3 |

*2 : remarkably reacted with Pt - Rh

*3 : anomalous phases (CaCuO and BiSrO groups) are caused.

high (in the cases of 3 - 5 -- 3 - 7 and 4 - 4 -- 4 - 6). On the other hand, any of comparison examples 3 - 8 -- 3 - 7 and 4 - 7 -- 4 - 10 in which the mixing ratio of CuO powder and their heat processing temperatures were out of the range of the present invention has low Jc. Particularly in the case of comparison examples 3 - 11 and 4 - 10 in which no CuO powder was mixed and of comparison examples 3 - 8 and 4 - 7 in which the mixing ratio of CuO powder was too low, anomalous phases (CaCuO group, BiSrO group) are caused.

14

Example 15:

Ceramic superconductive matter powder having a composition of $YBa_2Cu_3O_{7-\delta}$ ($\delta$ = 0.1 - 0.3) was filled in an SUS 304 stainless steel pipe which had an outer diameter of 10 mm$\phi$, an inner diameter of 9 mm$\phi$ and a length of 100 mm (filled density: 60%). The stainless steel pipe in which the powder has been filled was elongated to a wire having an outer diameter of 1 mm$\phi$, the wire was locally heated by the high frequency coil to melt the powder in the wire, and zone melting was applied to the wire, feeding it at a speed of 1 mm/min, to thereby solidify the melt in a direction. The high frequency heating and the cooling following this heating were carried out in oxygen-abundant atmosphere in which oxygen partial pressure was 0.9. The wire product thus obtained has a high filled density of 99% and a remarkable face-C-arranged orientation. Critical temperature (Tc) is 94 and critical current density (Jc) under the liquid nitrogen temperature and at 0 Tesla is $5 \times 10^3$ A/cm$^2$.

[Comparison Example 4]

Ceramics superconductive powder whose composition is represented by $YBa_2Cu_3O_{7-\delta}$ ($\delta$ = 0.1 to 0.3) was filled in a SUS304 stainless pipe (filling density: 60%) having an outer diameter of 10 mm$\phi$, an inner diameter of 9 mm$\phi$, and a length of 100 mm. This pipe is drawn until the outer diameter thereof becomes to be 1 mm, and was sintered in an atmosphere of 900°C x 10hr. The wire thus obtained has a filling density of 90%, a critical temperature (Tc) of 93K, a temperature of liquid nitrogen, and a critical current density (Jc) at 0 Tesla of $2 \times 10^2$ A/cm$^2$.

Then, the invention of subclaim 4 will now be described with reference to Examples 16 and 17 and comparison Example 5.

[Example 16]

Ceramics superconductive powder whose composition is represented by $YB_2Cu_3O_{7-\delta}$ ($\delta$ = 0.1 to 0.3) was mixed with 2% of silver peroxide, and the mixture powder thus obtained was the mixed powder was filled in a platinum pipe which had an outer diameter of 10 mm$\phi$, an inner diameter of 9.5 mm$\phi$ and a length of 100 mm (filled density: 60%) The platinum pipe in which the powder had been filled was elongated to a wire which had an outer diameter of 1 mm$\phi$, using the roller dies. 19 pieces of these wires were used to form a twisted wire which had a pitch of 10 mm. The twisted wire was passed through a high frequency coil which had an inner diameter of 10 mm$\phi$ and a length of 20 mm to thereby melt the powder in the wires by high frequency heat. Zone melting was carried out by moving the twisted wire in the longitudinal direction thereof at a feeding speed of 1 mm/min through the continuous melting zone. Air cooling was continuously applied to the twisted line to solidify the melt in a direction.

The twisted wire product thus obtained had a high filled density of 99% and a remarkable orientation in which faces C of crystals were arranged along the longitudinal direction of the wire. Critical temperature (Tc) and critical current density (Jc) in the longitudinal direction of the wire were high accordingly, showing Tc of 94K and Jc of $7 \times 10^3$ A/cm$^2$ under the liquid nitrogen temperature and 0Tesla.

Example 17:

Ceramic superconductive matter powder having a composition of $YBa_2Cu_3O_{7-\delta}$ ($\delta$ = 0.1 - 0.3) was filled in an SUS 304 stainless steel pipe which had an outer diameter of 10 mm$\phi$, an inner diameter of 9 mm$\phi$ and a length of 100 mm (filled density: 60%). The stainless steel pipe in which the powder had been filled was elongated in same way as in Example 16 to a wire which had an outer diameter of 1 mm$\phi$. 19 pieces of these wires were bundled to a twisted wire, which was then made to a coil having an outer diameter of 100 mm$\phi$ and 10 turns. The end of the coil was locally heated, using same high frequency coil as that in Example 16, to melt the powder in the coil. Zone melting was applied to the coil-like line material, feeding it in its longitudinal direction at a speed of 1 mm/min while being rotated, and the melt was the solidified in a direction. The high frequency heating and the cooling following this heating were carried out in oxygen-abundant atmosphere in which oxygen partial pressure was 0.9.

The coil product thus obtained showed that each of the wire materials had a high filled density of 99% and a remarkable face-C-arranged orientation same as that in Example 16. Critical temperature (Tc) was 94K and critical current density was $5 \times 10^2$/cm$^2$ under the liquid nitrogen temperature and 0 Tesla

Comparison example 5:

Ceramic superconductive matter powder having a composition of $YBa_2Cu_3O_{7-\delta}$ ($\delta$ = 0.1 - 0.3) was filled in an SUS 304 stainless steel pipe which had an outer diameter of 10 mm$\phi$, an inner diameter of 9 mm$\phi$ and a length of 100 mm (filled density: 60%). The stainless steel pipe in which the powder had been filled was elongated in same way as in Example 16 to a wire which had an outer diameter of 1 mm. 19 pieces of these wires were used to form a twisted wire whose pitch was 10 mm. The twisted wire was sintered for 10 hours at 900°C in air. The twisted wire product thus obtained had a filled density of 90%. Critical temperature (Tc) was 92K and critical current density (Jc) was $2 \times 10^2 A/cm^2$ under the liquid nitrogen temperature and 0 Tesla.

**Claims**

1. A method of manufacturing superconductive products comprising heating an elongate body in which a superconductive material (5) or its precursor is filled, to a temperature higher than the melting point of the superconductive material or its precursor to melt the material or its precursor, and cooling the elongate body in a manner to solidify and unidirectionally re-crystalize the melt therein.

2. The method according to claim 1, characterized in that said body is made by fixing the superconductive material (5) or its precursor onto a heat-resisting base.

3. The method according to claim 1, characterized in that said body is a wire prepared by filling the superconductive material (5) or its precursor into a metal sheath.

4. The method according to claim 1, characterized in that said body is prepared by filling the superconductive material (5) or its precursor into the metal sheath and bending a plurality of the wire-like metal sheaths to a desired form.

5. The method according to claim 1, characterized in that the superconductive material (5) or its precursor is of the oxide type.

6. The method according to claim 1, characterized in that heating and cooling of the superconductive material (5) or its precursor are carried out in oxygen-abundant atmosphere.

7. The method according to claim 3 or 4, characterized in that a small amount of metal peroxide is previously mixed with the superconductive material (5) or its precursor which is to be made to fill the metal sheath.

8. The method according to claim 1, characterized in that said superconductive material (5) is an oxide-based superconductive body selected from the group consisting of $ReBa_2Cu_3O_{7-x}$, $(Re_{1-x}Re_x)$-$Ba_2Cu_3O_{7-y}$, $Bi-Sr-Ca-Cu_2-Ox$, and $Tl_2-Ba_2-Ca_2-Cu_3-Ox$, where Re is a rare-earth element.

9. The method according to claim 1, characterized in that said precursor of the superconductive material (5) is one selected from the group consisting of an oxide, a hydroxide, a halide, a salt of an inorganic acid such as a carbonate or a nitrate, an acetate, an oxalate, an alcoxide, which all include a constituent element of an oxide superconductive body including at least an alkali earth metal and copper.

**Patentansprüche**

1. Verfahren zur Herstellung von supraleitenden Produkten, umfassend die Schritte des Erwärmens eines Dehnungskörpers, in den ein supraleitendes Material (5) oder sein Vorläufer gefüllt wird, auf eine höhere Temperatur als der Schmelzpunkt des supraleitenden Materials oder seines Vorläufers, um das Material oder seinen Vorläufer zu schmelzen, und Kühlen des Dehnungskörpers in einer Art und Weise, um die Schmelze darin zu verfestigen und unidirektional zu rekristallisieren.

2. Verfahren nach Anspruch 1, dadurch gekennzeichnet, daß der Körper hergestellt wird, indem das supraleitende Material (5) oder sein Vorläufer auf eine wärmebeständige Basis befestigt wird.

3. Verfahren nach Anspruch 1, dadurch gekennzeichnet, daß der Körper ein Draht ist, der hergestellt ist, indem das supraleitende Material (5) oder dessen Vorläufer in eine Metallhülle gefüllt wird.

**4.** Verfahren nach Anspruch 1, dadurch gekennzeichnet, daß der Körper hergestellt wird, indem das supraleitende Material (5) oder sein Vorläufer in die Metallhülle gefüllt wird und eine Vielzahl von drahtartigen Metallhüllen in eine gewünschte Form gebogen werden.

**5.** Verfahren nach Anspruch 1, dadurch gekennzeichnet, daß das supraleitende Material (5) oder sein Vorläufer vom Oxidtyp ist.

**6.** Verfahren nach Anspruch 1, dadurch gekennzeichnet, daß Erwärmen und Kühlen des supraleitenden Materials (5) oder seines Vorläufers in einer sauerstoffreichen Atmosphäre durchgeführt wird.

**7.** Verfahren nach Anspruch 3 oder 4, dadurch gekennzeichnet, daß eine kleine Menge von Metallperoxiden vorher mit dem supraleitenden Material (5) oder seinem Vorläufer gemischt wird, das in die Metallhülle gefüllt werden soll.

**8.** Verfahren nach Anspruch 1, dadurch gekennzeichnet, daß das supraleitende Material (5) ein supraleitender Körper auf einer Oxidbasis ist, der aus der Gruppe bestehend aus $ReBa_2Cu_3O_{7-x}$, $(Re_{1-x}Re_x)Ba_2Cu_3O_{7-y}$, Bi-Sr-Ca-Cu$_2$-Ox, und Tl$_2$-Ba$_2$-Ca$_2$-Cu$_3$-Ox besteht, wobei Re ein Edel-Bodenelement ist.

**9.** Verfahren nach Anspruch 1, dadurch gekennzeichnet, daß der Vorläufer des supraleitenden Materials (5) aus der Gruppe ausgewählt ist, die aus einem Oxid, einem Hydroxid, einem Halogenid, einem Salz einer anorganischen Säure wie z.B. einem Karbonat oder einem Nitrat, einem Acetat, einem Oxalat, einem Alcoxid besteht, die alle einen Bestandteil eines oxid-supraleitenden Körpers einschließlich wenigstens eines Alkali-Bodenmetalls oder Kupfer enthalten.

**Revendications**

**1.** Procédé de fabrication de produits supraconducteurs, comprenant le chauffage d'un corps allongé dans lequel est chargé un matériau supraconducteur (5) ou un précurseur de celui-ci, à une température supérieure à la température de fusion du matériau supraconducteur ou de son précurseur afin que le matériau ou son précurseur fonde, et le refroidissement du corps allongé de manière que la matière fondue placée à l'intérieur se solidifie et recristallise de manière unidirectionnelle.

**2.** Procédé selon la revendication 1, caractérisé en ce que le corps est formé par fixation du matériau supraconducteur (5) ou de son précurseur sur une base résistant à la chaleur.

**3.** Procédé selon la revendication 1, caractérisé en ce que le corps est un fil métallique préparé par remplissage du matériau supraconducteur (5) ou de son précurseur dans une gaine métallique.

**4.** Procédé selon la revendication 1, caractérisé en ce que le corps est préparé par remplissage du matériau supraconducteur (5) ou de son précurseur dans la gaine métallique, et par flexion de plusieurs gaines métalliques analogues à des fils à la configuration voulue.

**5.** Procédé selon la revendication 1, caractérisé en ce que le matériau supraconducteur (5) ou son précurseur est du type d'un oxyde.

**6.** Procédé selon la revendication 1, caractérisé en ce que le chauffage et le refroidissement du matériau supraconducteur (5) ou de son précurseur sont réalisés en atmosphère ayant de l'oxygène en abondance.

**7.** Procédé selon la revendication 3 ou 4, caractérisé en ce qu'une petite quantité d'un peroxyde métallique est préalablement mélangée au matériau supraconducteur (5) ou à son précurseur qui doit être utilisé pour le remplissage de la gaine métallique.

**8.** Procédé selon la revendication 1, caractérisé n ce que le matériau supraconducteur (5) est un corps supraconducteur à base d'un oxyde, choisi dans le groupe formé par $ReBa_2Cu_3O_{7-x}$, $(Re_{1-x}Re_x)Ba_2Cu_3O_{7-y}$, Bi-Sr-Ca-Cu$_2$-Ox, et Tl$_2$-Ba$_2$-Ca$_2$-Cu$_3$-Ox, Re étant un élément des terres rares.

**9.** Procédé selon la revendication 1, caractérisé en ce que le précurseur du matériau supraconducteur (5) est choisi dans le groupe comprenant un oxyde, un hydroxyde, un halogénure, un sel d'un acide minéral tel qu'un carbonate ou un nitrate, un acétate, un oxalate, un alcoxyde, qui contiennent tous un élément constituant d'un corps supraconducteur d'oxyde contenant au moins un métal alcalinoterreux et du cuivre.

EP 0 304 076 B1

F I G. 1

19